# EUROPEAN PATENT APPLICATION

(11) **EP 2 501 000 A1**
(43) Date of publication of application: **19.09.2012**
(21) Application number: 11290131.9
(22) Date of filing: 14.03.2011
(51) Int. Cl.: H01S 5/50, H01S 5/0625, H04B 10/12

(54) **High radio range using two-section RSOAs**

(71) Applicant: Alcatel Lucent, 75007 Paris (FR)
(72) Inventor: de Valicourt, Guilhem, 75010 Paris (FR); Brenot, Romain, 75001 Paris (FR); Lamponi, Marco, 75015 Paris (FR)
(74) Representative: MERH-IP Matias Erny Reichl Hoffmann

(57) **Abstract**

The present document relates to optical transmission systems. In particular, the present document relates to a colorless optical emitter for radio over fiber applications. A reflective semiconductor optical amplifier (400), referred to as RSOA, is described. The RSOA comprises an input/output port (307) configured to receive an optical signal at and/or emit an optical signal from the RSOA (400); an optical waveguide (305) traversing a first section (403) and a second section (402) of the RSOA (400) and configured to guide the optical signal; the first section (403) comprising a modulation electrode (413) configured to apply a modulated bias current; the second section (402) comprising an amplification electrode (412) configured to apply a continuous bias current; and a reflective section (304) configured to reflect the optical signal; wherein the first section (403) is positioned closer to the input/output port (307) than the second section (402).

## Description

The present document relates to optical transmission systems. In particular, the present document relates to a colorless optical emitter for radio over fiber (RoF) applications, which may e.g. be used in wavelength division multiplexing systems.

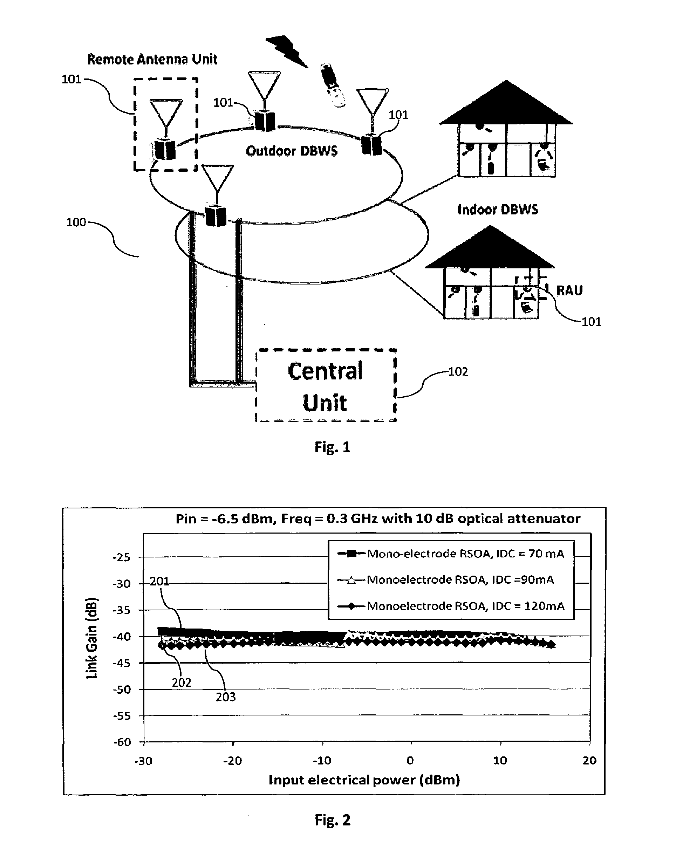

The bandwidth need for mobile connectivity is rapidly increasing in today networks. New kinds of users emerge and want to enjoy the same quality for mobile multimedia services as for fixed networks. A shift towards mobile devices and on-the-road connectivity drives the network architecture to converge into a combined access and radio-over-fiber (RoF) network 100 as illustrated in Fig. 1. In this context, WLAN hot-spots or third-generation (3G) wireless networks are typically already able to establish wide-area wireless connectivity for services such as voice telephone, video calls, and wireless data, all in a mobile environment. Radio-over-fiber (RoF) technology enables different types of services to be combined into a homogenous infrastructure using DAS (Distributed Antenna System), which is very attractive for next generation wireless networks. A DAS typically comprises a large number of remote antenna units (RAU) 101 over the coverage area and a central unit (CU) 102.

In order to obtain a wide service coverage area, a high number of RAUs 101 should typically be connected to a Central Unit (CU) 102 via an optical fiber network. Efficient architectures have been proposed using WDM techniques, allowing a reconfigurable radio over fiber network (RoFnet). The high bit rates envisioned for 4th generation wireless networks (4G) can be provided by a hybrid optical-radio infrastructure which is being developed in the FUTON (fibre optic networks for distributed, extendible heterogeneous radio architectures and service provisioning) project.

However, in these new architectures, the same cost and performances issues appear as in conventional access networks. Various radio-over-fiber link types have been investigated in terms of cost, performance, flexibility and simplicity. The radio channels can be carried using subcarrier multiplexing (SCM), where the channels are frequency translated to intermediate frequencies (IF). This architecture may be referred to as IF-over-Fiber architecture, where an IF (Intermediate Frequency) radio signal with a lower frequency (typically less than 10 GHz) is used for modulating light before being transported over the optical link. In such IF-over-Fiber systems, wireless signals are transported at an intermediate frequency over the optical fiber. This limits the transmission requirements to lower frequencies. A Reflective Semiconductor Optical Amplifier (RSOA) is a good candidate at moderate IF (below 1 GHz). Such an RSOA may satisfy most of the requirements imposed on the electrical-to-optical (E/O) converter.

In most wireless systems the uplink direction, i.e. the direction from the mobile station or mobile terminal to the network, is typically a limiting factor in determining the coverage range of the DAS. This is mainly due to the relatively low transmit power from the mobile terminal. RSOAs have been optimized for RoF applications and show high linearity and low noise level which are important in the radio range calculation.

However, it has been demonstrated that DMLs (Direct Modulated Lasers) typically show higher performances (with regards to the overall radio range of the DAS), which is partially due to a higher link gain at the E/O interface. Table 1 shows a comparison of typical values for measured RoF LINK PARAMETERS between DML, RSOA and MZM (Mach Zehnder Modulated) links:

**Table 1**

| Parameter | DML | MZM | RSOA |
|---|---|---|---|
| Link gain, dB | -28 | -42 | -42 |
| output noise power, dBm/Hz | -159 | -167 | -165 |

The present document relates to the technical problem of increasing the radio range using RSOA devices. In particular, the present document relates to providing RSOA devices for RoF applications which allow for higher link gains and reduced noise levels and which support increased maximum input power of the transmitted radio signal.

According to an aspect a reflective semiconductor optical amplifier (RSOA), in particular a two-section RSOA, is described. The RSOA may comprise an input/output port configured to receive an optical signal at the RSOA and configured to emit an optical signal from the RSOA. A continuous wave signal may be received at the input/output port of the RSOA. The RSOA may be configured to modulate and/or amplify the continuous wave signal and to emit the resulting modulated and/or amplified optical signal via the input/output port. The continuous wave signal and the modulated and/or amplified optical signal may be at a first wavelength, i.e. both optical signals may have the same wavelength. In other words, the RSOA may amplify and/or modulate the optical signal received at the RSOA and send it back to the network.

The RSOA may comprise an optical waveguide traversing a first section and a second section of the RSOA. The optical waveguide may be configured to guide the optical signal. In particular, the optical waveguide may be configured to guide a continuous wave signal from the input/output port through the first and/or second section of the RSOA. In a similar manner, the optical waveguide may be configured to guide a modulated and/or amplified optical signal, which has been generated from the continuous wave signal within the RSOA. The optical waveguide may be configured to guide the modulated and/or amplified optical signal towards the input/output port, such that the modulated and/or amplified optical signal may be emitted by the RSOA.

The RSOA may comprise a first section. The first section may comprise a modulation electrode configured to apply a modulated bias current. The modulation electrode may cover the entire length of the first section. As such, the first section may be configured to modulate an optical signal traversing the first section. In particular, the first section may be configured to generate a modulated optical signal from the continuous wave signal. The modulation may be performed according to the modulation of the modulated bias current. The modulated bias current may comprise a continuous bias current component which is modulated by a modulation signal. The modulation signal may be representative of data which is to be transmitted via the modulated optical signal.

The RSOA may comprise a second section. The second section may comprise an amplification electrode configured to apply a continuous bias current. The amplification electrode may cover the entire length of the second section. As such, the second section may be configured to amplify an optical signal traversing the second section. In particular, the second section may be configured to amplify the optical signal which has been modulated within the first section. For this purpose, a constant or continuous bias current may be applied

The RSOA may comprise a reflective section configured to reflect the optical signal. The reflective section may be implemented by an endface of the optical waveguide. Alternatively or in addition, the reflective section may be implemented by a reflective coating at the remote end, opposite of the input/output port, of the second section and/or of the RSOA. As such, the reflective section may be configured to reflect the amplified and/or modulated optical signal towards the input/ output port.

The first section may be positioned closer to the input/output port than the second section. In other words, the input/output port may be positioned upstream of the first section which may be positioned upstream of the second section which may be positioned upstream of the reflective section, wherein the term "upstream" refers to the direction of propagation of the continuous wave entering the RSOA. As such, a continuous wave entering an optical waveguide of the RSOA via the input/output port may first traverse the first section and then the second section prior to being reflected at the reflective section. As such, the continuous wave signal may first be modulated within the first section prior to being amplified within the second section.

The first section and/or the second section of the RSOA may comprise an active material comprising one or any appropriate combination of Gallium, Indium, Arsenide, Aluminium and/or Phosphorous. In particular, the first and second section may be implemented within a common photonic integrated circuit, e.g. on the same substrate. In particular, the first and second section of the RSOA may comprise the same active material. The first and second section may be separated using proton implantation between the first and second section.

The RSOA may further comprise a spot size converter section between the input/output port and the first section, wherein the spot size converter section may be configured to taper the optical waveguide. In other words, the spot size converter section may be configured to facilitate an optical coupling between the RSOA, e.g. the input/output port of the RSOA, and an optical waveguide, e.g. an optical fiber, connected to the RSOA, e.g. connected to the input/output port of the RSOA.

The length of the optical waveguide of the RSOA within the first section may be smaller or equal to the length of the waveguide of the RSOA within the second section. In other words, first section (where the modulation is applied to the optical signal within the optical waveguide) may be of equal length or shorter than the second section (where the amplification is applied to the optical signal within the optical waveguide). This may be beneficial in order to achieve a high internal efficiency of the RSOA.

The modulated bias current may be kept at or below a predetermined current value. In particular, the continuous bias current component comprised within the modulated bias current may be kept at or below the predetermined current value. The predetermined current value may depend on the size, e.g. the length, of the first section. In an embodiment, the predetermined current value is about 20mA. A limited modulated bias current may be beneficial in order to increase the link gain which may be achieved by the two-section RSOA in RoF applications.

According to another aspect, an optical emitter is described. The optical emitter may comprise a two-section RSOA according to any of the aspects outlined in the present document. The RSOA may comprise a modulation electrode within a first section of the RSOA. As outlined in the present document, the first section may be the section closer to the input/output port of the RSOA. Furthermore, the optical emitter may comprise a data port configured to receive a modulated electrical signal. By way of example, the modulated electrical signal may be a radio frequency antenna signal or an intermediate frequency signal derived from the radio frequency antenna signal. The data port may be linked to the modulation electrode. In particular, the modulated electrical signal may be combined with a continuous bias current component to yield the modulated bias current applied to the modulation electrode.

According to further aspect, a remote antenna unit for a Distributed Antenna System is described. The remote antenna unit may comprise an antenna configured to receive a radio signal and to convert the radio signal into a modulated electrical signal. Furthermore, the remote antenna system may comprise an optical emitter according to any of the aspects outlined in the present document. The optical emitter may be configured to convert the modulated electrical signal into a modulated optical signal. The modulated optical signal may be transmitted over a fiber infrastructure to a central unit. According to another aspect, a use of a reflective semiconductor optical amplifier comprising a first section having a modulation electrode and a second section having an amplification electrode for radio-over-fiber transmission is described. In other words, the use of a two-section RSOA for radio-over-fiber transmission is described.

According to further aspect, a method for generating an amplified and/or modulated optical signal at a first wavelength is described. The method may comprise the step of receiving a continuous wave signal at the first wavelength at a first section of a reflective semiconductor optical amplifier. By applying a modulated bias current to the first section, a modulated optical signal at the first wavelength may be obtained. Subsequently, the modulated optical signal may be received at a second section of a reflective semiconductor optical amplifier. The second section may be downstream of the first section. The method may proceed in applying a continuous bias current to the second section, thereby yielding an amplified and/or modulated optical signal. The amplified and/or modulated optical signal may be reflected at a position downstream of the second section.

It should be noted that the methods and systems including its preferred embodiments as outlined in the present patent application may be used stand-alone or in combination with the other methods and systems disclosed in this document. Furthermore, all aspects of the methods and systems outlined in the present patent application may be arbitrarily combined. In particular, the features of the claims may be combined with one another in an arbitrary manner.

The claimed subject-matter is explained below in an exemplary manner with reference to the accompanying drawings, wherein
Fig. 1 illustrates an example distributed antenna system;
Fig. 2 illustrates the link gain achieved using example mono electrode RSOAs;
Fig. 3 shows an example two-section RSOA;
Fig. 4a and Fig 4b show example two-section RSOAs adapted for RoF applications;
Fig. 5 shows example electrical/optical response measurements for two-section RSOAs;
Fig. 6a and 6b show example link gain and error vector magnitude measurements for two-section RSOAs;
Fig. 7 illustrates a radio range performance comparison for example one-section and two-section RSOAs; and
Fig. 8 shows an example measurement setup.

As indicated above, Fig. 1 illustrates an example distributed antenna system (DAS) 100 comprising a plurality of indoor and outdoor Distributed Broadband Wireless Systems (DBWS). A certain geographical area, which previously might have been covered by a single antenna, is divided into several serving areas, where remote access units (RAUs) 101 are located. The RAUs 101 are linked to a central unit (CU) 102, preferably using a transparent optical fiber system, and are able to send/receive signals from different wireless systems. In other words, antennas centrally attached to the base station in the conventional mobile systems may be distributed into the entire cell via a RoF network so that the transmission distance between mobile terminals and base stations can be shortened compared to a centralized antenna system. In addition to reducing the transmission distance and providing diversity, such a distributed antenna system allows the development of virtual multiple antenna transmission and/or reception concepts to achieve broadband wireless transmission, and also inter-cell interference cancellation. Moreover, reception of one signal at different locations provides diversity against fading.

Typically, the DAS 100 supports two types of modes to a mobile station or user terminal. A single attachment mode may be provided, where the user terminals communicate with a single RAU 101. In this mode, the fiber infrastructure between the RAUs 101 and the CU 102 provides a remoting of radio signals. Furthermore, a multiple attachment mode or distributed wireless system mode may be provided, for which the user terminals can communicate with several RAUs 101. For this mode, the fiber infrastructure provides a transparent transport network allowing the joint processing of the radio signals from the different RAUs 101.

The different DWBSs comprising the RAUs 101 are linked by an optical network infrastructure connecting the CU 102 and the remote access units (RAUs) 101. The optical network infrastructure may use radio over fiber technology such as radio frequency or intermediate frequency over fiber technology, which enables the co-operative processing of the antenna signals. Radio over fiber technology reduces the bandwidth requirements that would result from the digitization of a plurality of 100 MHz bandwidth DBWS channels that are transported to and from each RAU 101.

The radio range, i.e. the coverage range of a RAU, depends on various parameters, such as the link gain, the noise level and/or the maximum input power of the radio signal. These parameters are particularly influenced by the parameters which can be achieved within the RoF network, in particular within the E/O converters. The link gain of a link between a RAU 101 and the CU 102 typically describes the gain across the overall transmission channel comprising a first E/O converter at the RAU 101, the optical transmission channel (e.g. an optical fiber), and a second E/O converter at the CU 102. In a similar manner, the noise level of the link describes the noise introduced across the overall transmission channel. The maximum input power of the radio signal, for an acceptable level of EVM (error vector magnitude) of e.g. 4% or lower, corresponds to the input power of the electrical signal which is used to modulate the first and/or second E/O converter.

An optimization on the RSOA device itself may be done, e.g. by changing the optical confinement. Such an optimization of the RSOA device provides a higher radio range which is due to the noise level reduction. However, the RF gain stays the same. In classic (one section) RSOA, the link gain depending on the bias current I_{DC} typically stays substantially constant as illustrated in Fig. 2. Fig. 2 illustrates the link gain 201, 202, 203 for different I_{DC} of a mono-electrode RSOA. It can be seen that the level of bias current has almost no influence on the link gain which may be achieved.

The addition of an extra amplifier into the RF link may be used to provide an extra gain, but the addition of extra amplifiers is expensive and is typically not feasible in low cost networks.

It is proposed in the present document to use a carefully designed 2-section RSOA, in order to be able to control at the same time, the link gain, the noise level and the maximum input power.

2-section RSOA may be used in access networks. A first application of 2-section RSOAs may be to increase the electro-optical bandwidth. The use of two-section RSOA may lead to -3dB bandwidth higher than 6 to 7 GHz. Another useful application may be to use 2-section RSOAs in order to reduce the chirp leading to lower transmission penalties. In the present document, 2-section RSOAs are described for the use within an R-o-F Network.

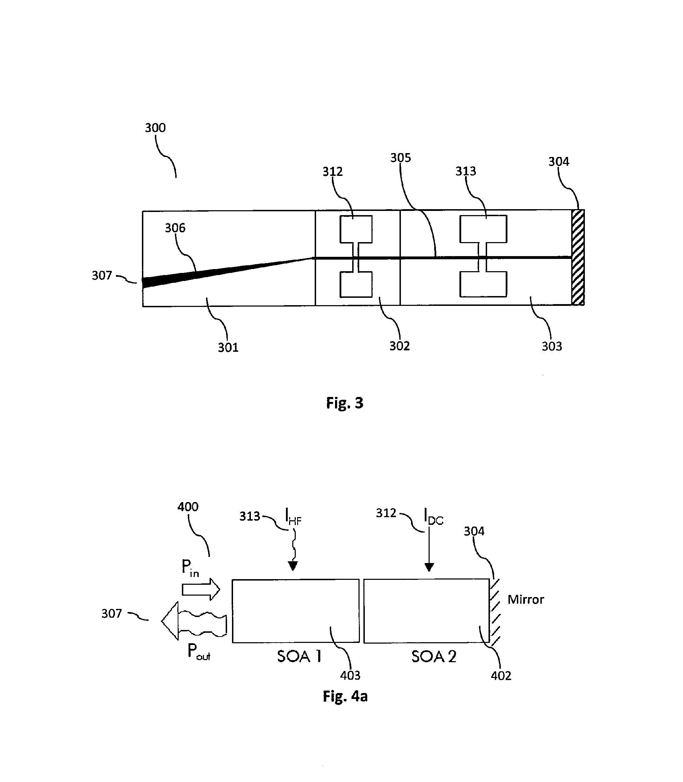

Two-section RSOAs may be used for provide high modulation bandwidth. An example of such a two-section RSOA is illustrated in Fig. 3. The two-section RSOA 300 of Fig. 3 is modulated using a mirror electrode 313 which provides high E/O (electrical / optical) bandwidth under analogue electrical modulation. The high modulation bandwidth of such a two-section RSOA 300 is obtained by using a large modulated electrode 313. The two-section RSOA 300 comprises a spot size converter (SSC) 301, which is a taper section for increasing the spot size 306 of the optical waveguide 305. The SSC 301 may be implemented as an angled or tilted waveguide 305 as illustrated in Fig. 3. Such a SSC 301 is optional and is used to improve the coupling to a fibre at the input/output port 307 at the front side of the RSOA 300. The RSOA 300 further comprises a first section 302, where a bias current I_{DC} is applied to the electrode 312. This section 302 provides for an amplification of the optical signal confined within the waveguide 305. Furthermore, the RSOA 300 comprises a second section 303 where a modulated DC current is applied to the electrode 313. In addition, the RSOA 300 comprises a reflective section, herein also referred to as mirror 304 at the rear side of the RSOA 300. The mirror 304 may be implemented using a highly reflective region and/or an air gap.

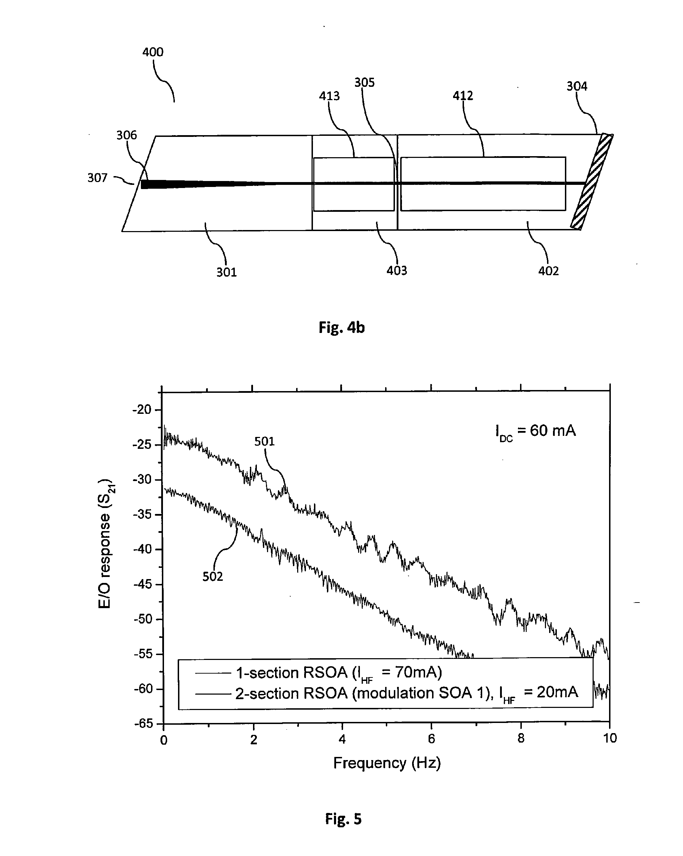

In the present document, a two-section RSOA is described which is specifically adapted to the requirements of RoF applications. Such an RSOA 400 is illustrated in Fig. 4. At the input/output port 307 at the front side of the two-section RSOA 400, a continuous wave (CW) optical signal at a desired wavelength and at a certain optical power Pin may be coupled into the RSOA 400. The CW signal traverses a first section 403 where the CW signal is modulated by a modulated current I_{HF} 313. The modulated current I_{HF} 313 has been obtained e.g. by modulating a DC current with the radio input signal coming from an antenna. By applying the modulated current I_{HF} 313 to the semiconductor material of the RSOA 400 in the first section 403, the optical CW signal within a waveguide 305 (illustrated e.g. in Fig. 4b) is modulated, thereby yielding a modulated optical signal. This modulated optical signal enters the second section 402, where the modulated optical signal is amplified by the application of a bias current I_{DC} 312.

Using a reflective section 304, the modulated optical signal is sent back through the RSOA 400 towards the input/ output port 307, thereby yielding an amplified and modulated optical signal having an output power Pout. This modulated optical signal is transmitted over an optical fiber (e.g. from the RAU 101 to the CU 102).

Fig. 4b shows an example RSOA 400 comprising an SSC 301. Instead of a tilted waveguide 305 within the SSC 301, the endface of the RSOA 400 at the input / output port 307 and/or at the reflective section 304 may be tilted. This is an alternative embodiment to the use of a tilted waveguide 305 as illustrated in Fig. 3.

Furthermore, in Fig. 4b the electrodes 413 and 412 of the first section 403 and the second section 402 are illustrated. In the illustrated example, the first section 403 (where the modulation of the CW signal is performed) is shorter than the second section 402 (where the amplification of the modulated optical signal is performed). Furthermore, the modulation electrode 413 is smaller than the amplification electrode 412. It has been observed that these relative dimensions of the first 403 and second 402 section and/or of the modulation electrode 413 and the amplification electrode 412 provide a two-section RSOA 400 which enables an increased radio range of the RAU 101, due to an increased internal efficiency. In other words, in a preferred embodiment the modulated electrode 413 and/or the first section 403 should be the same length or shorter as the amplification electrode (also referred to as mirror electrode) 412 and/or the second section 402, in order to optimize the effect of gain link improvement. Furthermore, the modulated electrode (also referred to as first electrode) 413 should be situated at the input 307 of the device 400.

In an embodiment, the bias current I_{DC} 312 which is applied to the amplification electrode 412 in the second section 402 should be above a or at a predetermined current level (e.g. 50mA). It has been observed that when decreasing the bias current I_{DC} 312 below the predetermined current level, the achievable link gain may decrease.

As such, a double section RSOA 400 is described, where the modulation of the optical signal is applied on the first section 403 near the input/output of the RSOA 400. The proposed RSOA configuration 400 works for analog modulation and digital modulation and induces low chirp which makes the configuration 400 suitable for access networks.

Radio range improvement in the context of RoF may be demonstrated. In order to increase the radio range, the link gain can be improved using the bi-electrode RSOA device 400. This is illustrated in Fig. 5. In the context of the double section RSOA 400, the microwave modulation may be applied on the first electrode 413, e.g. with a 20 mA bias current. Another bias current of above 20mA, e.g. 60 mA, may be applied on the mirror electrode 412. In a mono-electrode configuration, i.e. in a one section RSOA, the bias current to the only electrode may be about 70mA. The above mentioned current values correspond to optimized conditions in order to obtain a high link gain. The frequency response of both devices is illustrated in Fig. 5. It can be seen that S₂₁ values, i.e. Electrical / optical responses, (at f = 0 GHz) of -23.5 dB (reference numeral 501) and -31.5 dB (reference numeral 502) are obtained using respectively a dual- and a mono-electrode RSOA. Therefore, an improvement of 8 dB is observed when using the described two-section RSOA 400 in comparison with a one-section RSOA. It should be noted that S₂₁ values at f = 0 GHz are proportional to link gain values. Consequently, Fig. 5 provides an indication of the improvement of the link gain which may be achieved when using two-section RSOAs 400. Further measurements of the link gain are provided below.

As indicated above, the optimal link gain may depend on the bias current of the mirror and/or input electrode 412/413, i.e. on the bias current of the amplification electrode 412 and/or the modulation electrode 413. When analyzing the E/O response of the bi-electrode device 400 as a function of increasing bias current I_{HF} applied to the modulation electrode 413, it can be seen that a small variation of 30mA of the bias current I_{HF} may induce a reduction of 3.5 dB on the link gain (represented by the S₂₁ values at OGHz). In particular, it can be seen that for high bias currents I_{HF} (around 100mA) the link gain may be lower than for relatively low bias currents I_{HF} (around 10 to 20mA).

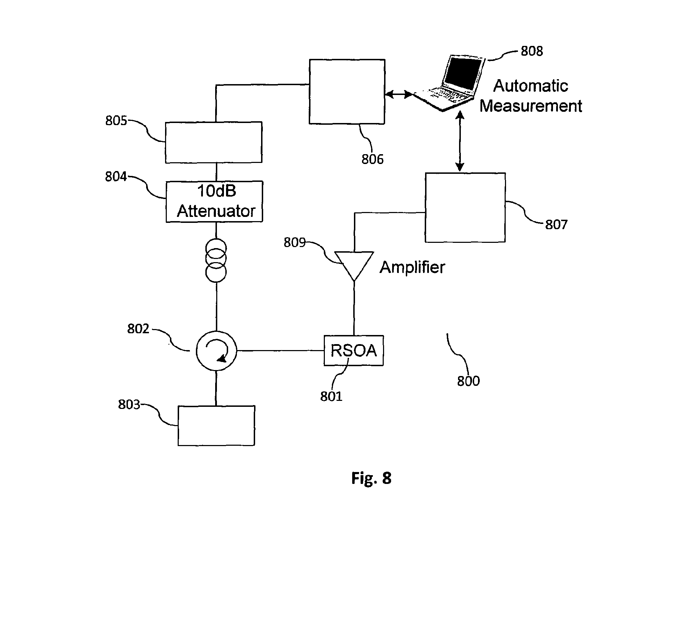

Electro-optical bandwidth measurements as illustrated in Fig. 5 are useful to have a qualitative idea of the link gain increase which may be achieved using the described two-section RSOA 400. However, the link gain improvement should be properly quantified. The measurement set up 800 of Fig. 8 may be used in order to directly measure the EVM (error vector magnitude), link gain and noise values for RoF transmission systems.

An optical power of e.g. -6.5 dBm (i.e. a continuous wave (CW) signal) is launched from a laser 803, e.g. a Teradian laser, into the RSOA device 801 through an optical circulator (OC) 802. The RSOA device 801 may be a one-section RSOA or a two-section RSOA 300, 400. The one-section RSOA device is biased at different input currents (e.g. 70, 90 and 120 mA). In case of a two-section RSOA 300 or 400, the bias currents on the modulation electrodes 313, 413 and the amplification electrodes 312, 412 may be varied and depend on the respective electrode position (in the first section 302, 403 or the second section 303, 402). An 802.11n (MCS 7, 40MHz) signal emulated for example by using an Agilent E4438C VGS 807 may be amplified (reference numeral 809) and fed to the RSOA 801 for transmission over the optical link. A frequency of 0.3 GHz may be used for the signal in order to investigate the lower limits of the RAU transmission frequencies (as defined e.g. in the FUTON standard). A 10dB optical attenuator 804 may be included in the optical link to represent losses such as losses caused by CWDM (coarse wavelength division multiplexer) in radio over fiber systems. The optical link may be terminated for optical to electrical conversion for example by an Appointech photodiode 805. The electrical signal may be analyzed by a spectrum analyzer 806, e.g. an Agilent E4440A spectrum analyzer. The overall measurement may be controlled using e.g. Agilent VSA software 808.

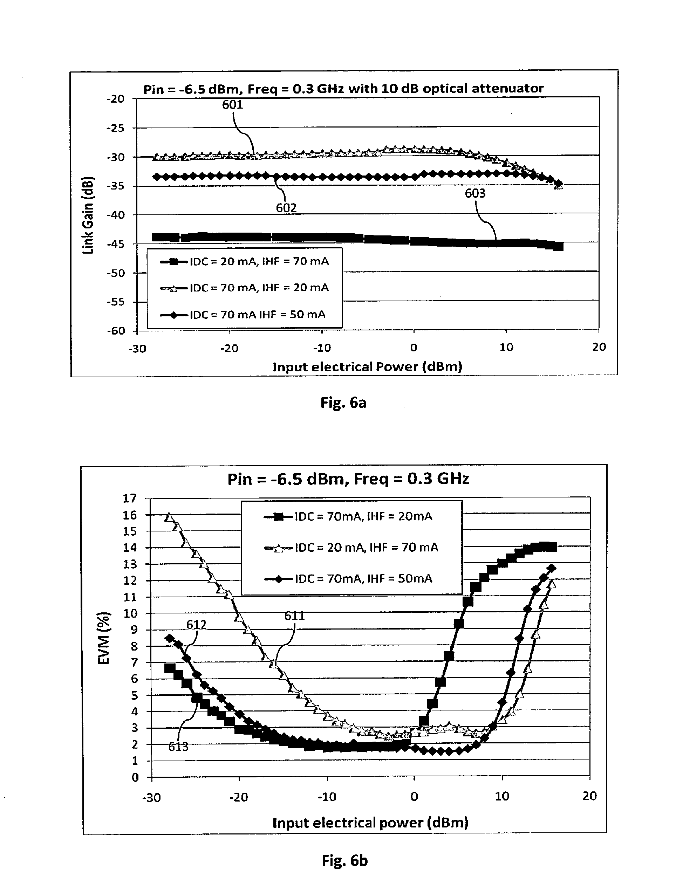

Fig. 6a illustrates the link gains which may be achieved when using two-section RSOA 400. These link gains are to be compared with the link gains shown in Fig. 2, which may be achieved with one-section RSOAs. It can be seen that an improvement of 10 dB may be achieved when appropriately selecting the operational conditions of the two-section RSOA 400. In particular, it can be observed that the link gain 601 can be improved when using relatively low bias currents on the modulation electrode 413. It can be seen that when using I_{HF}=20mA (link gain curve 601), the link gain is higher than when using I_{HF}=50mA (link gain curve 602) or I_{HF}=70mA (link gain curve 603).

Fig. 6b illustrates the error vector magnitude or error rate in % (an indication of the noise level and linearity) which may be achieved when using two-section RSOA 400. It is shown how different bias currents on the amplification electrode 412 (I_{DC}) and/or of the modulation electrode 413 (I_{HF}) may affect the maximum input power or the noise level. The maximum input power may depend on the linearity. It can be seen that for relatively small electrical input powers (e.g. coming from the antenna) which are used to modulate I_{HF} (in the range of -30dBm to OdBm) the EVM values can be reduced by increasing the bias current I_{DC} applied to the amplification electrode 412 (EVM curve 613 in comparison to EVM curve 611). It a similar manner to the link gain, it can be observed that by reducing the bias current I_{HF} on the modulation electrode 413, the EVM values can be reduced (EVM curve 613 in comparison to EVM curve 612). This can be seen on the left part of Fig. 6b and is due to low noise level. For higher electrical input powers (e.g. >OdBm), the non-linear effects within the RSOA 400 come into play. In this region, it may actually be beneficial to increase the bias current I_{HF} on the modulation electrode 413 (EVM curve 612 in comparison to EVM curve 613).

From Error Vector Magnitude (EVM) measurements, link gain and noise measurements, relevant parameters for mono-electrode and bi-electrode devices have been determined. These parameters are summarized in Tables 2a and 2b.

**Table 2a**

| Mono-electrode RSOA | I=70mA | I = 90mA | I=120mA |
|---|---|---|---|
| Output noise power per Hz [dB] | -167,24 | -163,438 | -160,098 |
| max. electrical input power (at 4% EVM) [dBm] | 7 | 10,1 | 12,5 |
| Link Gain (no amp) [dB] | -39,88 | -40,65 | -41,16 |
| Maximum radio range [m] | 440,4 | 435,3 | 425,4 |

**Table 2b**

| Bi-electrode RSOA (according | I_{DC}=20mA, | I_{DC}=70mA, | I_{DC}=70mA, |
|---|---|---|---|
| to Fig. 4a/4b) | I_{HF}=70mA | I_{HF}=20mA | I_{HF}=50mA |
| Output noise power per Hz [dB] | -169,564 | -168,156 | -169,076 |
| max. electrical input power (at 4% EVM) [dBm] | 11 | 1,9 | 9,7 |
| Link Gain (no amp) [dB] | -44 | -29,56 | -33,38 |
| Maximum radio range [m] | 450,7 | 471,9 | 477,4 |

As can be seen, a two-section RSOA allows to obtain high link gain values but also a low noise level while still allowing for a high maximum input power of the radio signal (coming e.g. from the antenna).

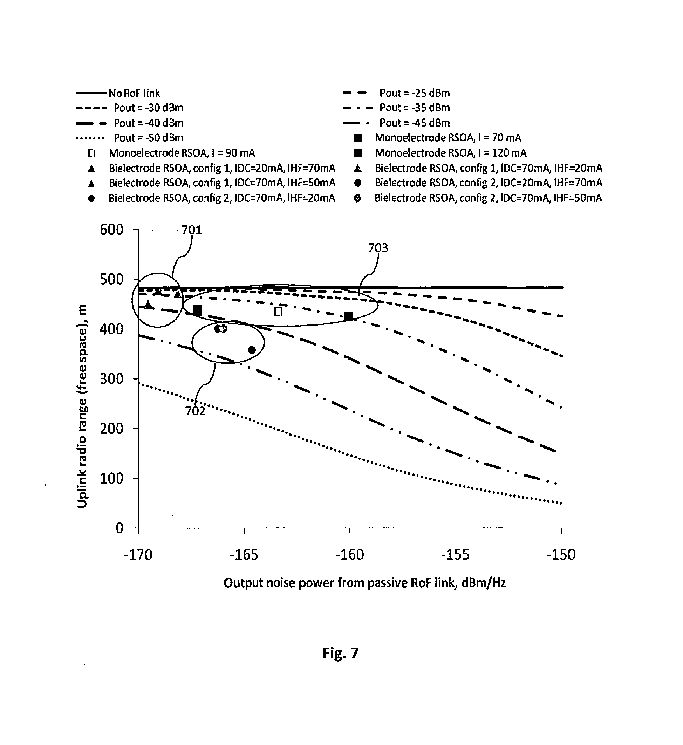

The achievable radio range calculated in meter (m) is represented in Fig. 7. The triangles correspond to the uplink radio range values which may be obtained using the RSOA configuration 400 (which in Fig. 7 is also referred to as "config 1"). It can be seen that this RSOAs 400 allows for high radio range values 701. This radio range values 701 are higher than the radio range values 703 which may be achieved using mono-electrode RSOAs and the radio range values 702 which may be achieved using bi-electrode RSOAs 300 (referred to in Fig. 7 as "config 2").

As a matter of fact, it can be seen that the radio range values 702 which are achievable using the two-section RSOA 300 (where the first section 303 is modulated) are worse than the radio range values 703 which are achievable using a one-section RSOA. This can also be seen from the relevant parameters listed in Table 2c for the two-section RSOA 300 (according to "config 2").

**Table 2c**

| Bi-electrode RSOA (according | IDC=20mA, | IDC=70mA, | IDC=70mA, |
|---|---|---|---|
| to Fig. 3) | IHF=70mA | IHF=20mA | IHF=50mA |
| Output noise power per Hz [dB] | -166,263 | -164,672 | -166,007 |
| max. electrical input power (at 4% EVM) [dBm] | 10 | -5,8 | 3,6 |
| Link Gain (no amp) [dB] | -45,57 | -31,38 | -39,29 |
| Maximum radio range [m] | 401,6 | 358 | 401,6 |

In the present document methods and systems for designing appropriate reflective semiconductor optical amplifiers for access network applications, in particular RoF applications, have been described. A cost-effective RSOA device with high performances has been described, which is applicable in novel network architectures, such as the next generation of wireless communication systems. The described solutions require relatively simple manufacturing processes, which makes these solutions cost effective. The described devices can be processed in a single chip and can be used for a large range of different wavelengths, therefore deployment cost can be reduced. Compared to classical RSOAs, the two-section RSOA may provide a higher radio range which leads to a reduced number of antennas and/or base stations and thereby reduces the deployment cost in RoF scenarios.

It should be noted that the description and drawings merely illustrate the principles of the proposed methods and systems. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the proposed methods and systems and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

In addition, it should be noted that the functions of the various elements described in the present patent document may be provided through the use of dedicated hardware as well as hardware capable of executing software in association with appropriate software.

Finally, it should be noted that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. A reflective semiconductor optical amplifier (400), referred to as RSOA, comprising
- an input/output port (307) configured to receive an optical signal at and/or emit an optical signal from the RSOA (400);
- an optical waveguide (305) traversing a first section (403) and a second section (402) of the RSOA (400) and configured to guide the optical signal;
- the first section (403) comprising a modulation electrode (413) configured to apply a modulated bias current;
- the second section (402) comprising an amplification electrode (412) configured to apply a continuous bias current; and
- a reflective section (304) configured to reflect the optical signal; wherein the first section (403) is positioned closer to the input/output port (307) than the second section (402).

2. The RSOA (400) of claim 1, wherein
- the input/output port (307) is configured to receive a continuous wave signal at a first wavelength at the RSOA (400) and to emit a modulated optical signal at the first wavelength from the RSOA (400);
- the optical waveguide (305) is configured to guide the continuous wave signal and the modulated optical signal;
- the first section (403) is configured to generate a modulated optical signal from the continuous wave signal;
- the second section (402) is configured to amplify the modulated optical signal; and
- the reflective section (304) is configured to reflect the amplified modulated optical signal towards the input/output port (307).

3. The RSOA (400) of any previous claim, further comprising
- a spot size converter section (301) between the input/output port (307) and the first section (413), configured to taper the optical waveguide (305).

4. The RSOA (400) of any previous claim, wherein the first section (403) and the second section (402) comprise an active material comprising one or a combination of Gallium, Indium, Arsenide, Phosphorous and/or Aluminium.

5. The RSOA (400) of any previous claim, wherein a length of the waveguide (305) within the first section (413) is smaller or equal than a length of the waveguide (305) within the second section (412).

6. The RSOA (400) of any previous claim, wherein the reflective section (304) is provided at an endface of the optical waveguide (305).

7. The RSOA (400) of any previous claim, wherein the modulation electrode (413) covers the entire length of the first section (403).

8. The RSOA (400) of any previous claim, wherein the modulated bias current is at or below a predetermined current value.

9. The RSOA (400), wherein the predetermined current value is about 20mA.

10. An optical emitter, comprising
- an RSOA (400) according to any of claims 1 to 9; wherein the RSOA (400) comprises a modulation electrode (413); and
- a data port configured to receive a modulated electrical signal; wherein the data port is linked to the modulation electrode (413).

11. The optical emitter of claim 9, wherein the modulated electrical signal is a radio frequency antenna signal or an intermediate frequency signal derived from the radio frequency antenna signal.

12. A remote antenna unit (101) for a Distributed Antenna System (100), the remote antenna unit (101) comprising:
- an antenna configured to receive a radio signal and to convert the radio signal into a modulated electrical signal; and
- an optical emitter according to any of claims 10 to 11 configured to convert the modulated electrical signal into a modulated optical signal.

13. Use of a reflective semiconductor optical amplifier (400) comprising a first section (403) having a modulation electrode (413) and a second section (402) having an amplification electrode (412) for radio-over-fiber transmission.

14. A method for generating an amplified modulated optical signal at a first wavelength, the method comprising
- receiving a continuous wave signal at the first wavelength at a first section (403) of a reflective semiconductor optical amplifier (400);
- applying a modulated bias current to the first section (403), thereby yielding a modulated optical signal at the first wavelength;
- receiving the modulated optical signal at a second section (402) of a reflective semiconductor optical amplifier (400), wherein the second section (402) is downstream of the first section (403);
- applying a continuous bias current to the second section (402), thereby yielding an amplified modulated optical signal; and
- reflecting the amplified modulated optical signal downstream of the second section (402).

## Amended claims

### Amended claims in accordance with Rule 137(2) EPC.

**1.** A reflective semiconductor optical amplifier (400), referred to as RSOA, comprising
- an input/output port (307) configured to receive an optical signal at and/or emit an optical signal from the RSOA (400);
- an optical waveguide (305) traversing a first section (403) and a second section (402) of the RSOA (400) and configured to guide the optical signal;
- the first section (403) comprising a modulation electrode (413) applying a modulated bias current to the first section (403);
- the second section (402) comprising an amplification electrode (412) applying a continuous bias current to the second section (402); and
- a reflective section (304) configured to reflect the optical signal; wherein the first section (403) is positioned closer to the input/output port (307) than the second section (402); and wherein a length of the waveguide (305) within the first section (403) is smaller than a length of the waveguide (305) within the second section (402).

**2.** The RSOA (400) of claim 1, wherein
- the input/output port (307) is configured to receive a continuous wave signal at a first wavelength at the RSOA (400) and to emit a modulated optical signal at the first wavelength from the RSOA (400);
- the optical waveguide (305) is configured to guide the continuous wave signal and the modulated optical signal;
- the first section (403) is configured to generate a modulated optical signal from the continuous wave signal;
- the second section (402) is configured to amplify the modulated optical signal; and
- the reflective section (304) is configured to reflect the amplified modulated optical signal towards the input/output port (307).

**3.** The RSOA (400) of any previous claim, further comprising
- a spot size converter section (301) between the input/output port (307) and the first section (413), configured to taper the optical waveguide (305).

**4.** The RSOA (400) of any previous claim, wherein the first section (403) and the second section (402) comprise an active material comprising one or a combination of Gallium, Indium, Arsenide, Phosphorous and/or Aluminium.

**5.** The RSOA (400) of any previous claim, wherein the reflective section (304) is provided at an endface of the optical waveguide (305).

**6.** The RSOA (400) of any previous claim, wherein the modulation electrode (413) covers the entire length of the first section (403).

**7.** The RSOA (400) of any previous claim, wherein the modulated bias current is at or below a predetermined current value.

**8.** The RSOA (400), wherein the predetermined current value is about 20mA.

**9.** An optical emitter, comprising
- an RSOA (400) according to any of claims 1 to 8; wherein the RSOA (400) comprises a modulation electrode (413); and
- a data port configured to receive a modulated electrical signal; wherein the data port is linked to the modulation electrode (413).

**10.** The optical emitter of claim 8, wherein the modulated electrical signal is a radio frequency antenna signal or an intermediate frequency signal derived from the radio frequency antenna signal.

**11.** A remote antenna unit (101) for a Distributed Antenna System (100), the remote antenna unit (101) comprising:
- an antenna configured to receive a radio signal and to convert the radio signal into a modulated electrical signal; and
- an optical emitter according to any of claims 9 to 10 configured to convert the modulated electrical signal into a modulated optical signal.

**12.** Use of a reflective semiconductor optical amplifier (400) comprising a first section (403) having a modulation electrode (413) and a second section (402) having an amplification electrode (412) for radio-over-fiber transmission; wherein a length of a waveguide (305) within the first section (403) is smaller than a length of the waveguide (305) within the second section (402).

**13.** A method for generating an amplified modulated optical signal at a first wavelength, the method comprising
- receiving a continuous wave signal at the first wavelength within a waveguide (305) at a first section (403) of a reflective semiconductor optical amplifier (400);
- applying a modulated bias current to the first section (403), thereby yielding a modulated optical signal at the first wavelength;
- receiving the modulated optical signal within the waveguide (305) at a second section (402) of a reflective semiconductor optical amplifier (400), wherein the second section (402) is downstream of the first section (403);
- applying a continuous bias current to the second section (402), thereby yielding an amplified modulated optical signal; and
- reflecting the amplified modulated optical signal downstream of the second section (402); wherein a length of the waveguide (305) within the first section (413) is smaller than a length of the waveguide (305) within the second section (412).
